# FASCICULE DE BREVET EUROPEEN

(11) **EP 1 081 848 B1**
(45) Date de publication et mention de la délivrance du brevet: **29.11.2006**
(21) Numéro de dépôt: 00402357.8
(22) Date de dépôt: 24.08.2000
(51) Int. Cl.: H03D 7/14

(54) **Dispositif de transposition de fréquence à faible fuite de signal d'oscillateur local et procédé correspondant de réduction de fuite**
Frequenzumsetzer mit unterdrücktem Lecksignal aus einem lokalen Oszillator und Verfahren
Frequency translator with suppressed leakage of the local oscillator , and process

(30) Priorité: 03.09.1999 FR 9911089
(43) Date de publication de la demande: 07.03.2001
(73) Titulaire: STMicroelectronics S.A., 92120 Montrouge (FR)
(72) Inventeur: Grasset, Jean-Charles, 38430 Moirans (FR)
(74) Mandataire: Casalonga, Axel

(56) Documents cités:
- EP-A- 0 040 274
- EP-A- 0 853 375
- US-A- 5 157 350
- US-A- 5 715 532

## Description

L'invention concerne la transposition de fréquence et s'applique avantageusement mais non limitativement dans le domaine de la radiofréquence, par exemple en téléphonie mobile, dans lequel les circuits radiofréquence utilisent largement des dispositifs de transposition de fréquence, ou mélangeurs de fréquence, tant à l'émission qu'à la réception.

A l'émission, les mélangeurs de fréquence, qui sont en l'espèce des circuits élévateurs de fréquence, ont pour but de transposer l'information en bande de base autour de la porteuse émission. En réception, les mélangeurs de fréquence sont des montages abaisseurs de fréquence.

La fonction de transposition de fréquence est critique, à la fois par ses compromis classiques (linéarité-consommation-facteur de bruit), mais aussi à cause de la contrainte d'isolation du signal provenant de l'oscillateur local vers le signal de sortie du mélangeur. Il est en effet fortement recommandé de minimiser la quantité résiduelle de signal d'oscillateur local dans le signal de sortie du mélangeur afin de faciliter la récupération de la porteuse de sortie.

A titre indicatif, si le signal d'entrée se situe à une fréquence comprise entre 100 et 400 MHz, et que l'on désire produire un signal de sortie autour de 1 ou 2 GHz, le signal d'oscillateur local, qui est calé sur une fréquence proche de 1 ou 2 GHz, se trouve alors proche de la porteuse synthétisée en sortie, rendant souvant difficile son filtrage ultérieur, tout au moins à un coût acceptable.

La fuite de signal d'oscillateur local vers le signal de sortie, qu'il convient de minimiser, est ici une fuite dite "structurelle", c'est-à-dire intrinsèque au mélangeur. En effet, une autre cause de fuite classiquement rencontrée est celle qui s'opère entre le point d'entrée de l'oscillateur local sur la puce contenant le mélangeur, et la sortie du mélangeur, par l'intermédiaire des éléments parasites du boîtier. Cette cause de fuite peut être, en l'état actuel de la technologie, facilement résorbée avec les boîtiers modernes.

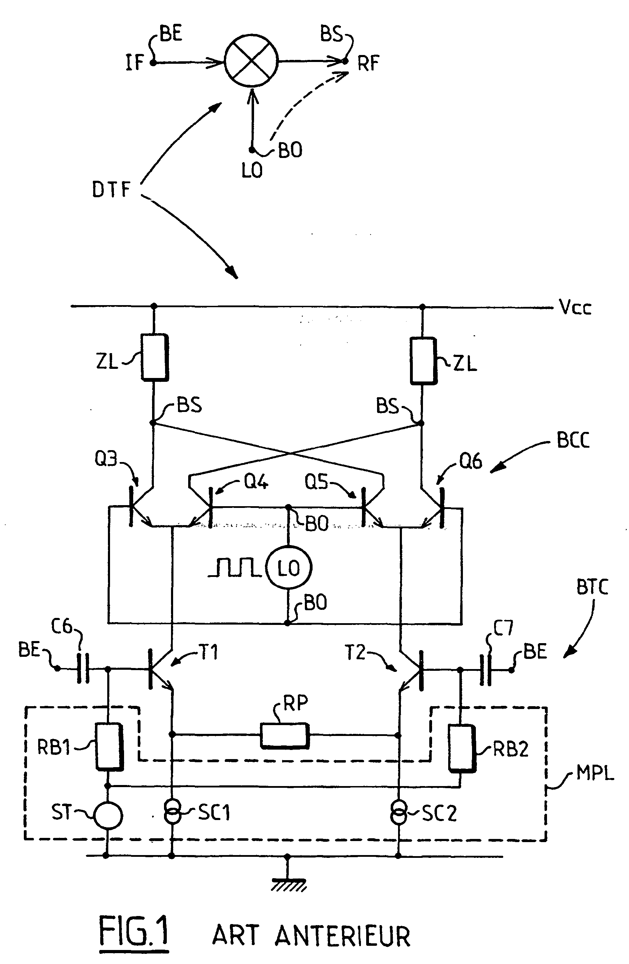

La figure 1 illustre schématiquement la structure habituellement utilisée pour les dispositifs de transposition de fréquence de l'art antérieur.

Sur la partie haute de la figure 1, la référence DTF désigne un dispositif de transposition de fréquence, ou mélangeur (ici élévateur de fréquence), possédant une borne d'entrée BE pour recevoir un signal d'entrée à une fréquence intermédiaire IF, par exemple 200 MHz, une borne BO pour recevoir le signal d'oscillateur local LO, par exemple à 2 GHz, et une borne de sortie BS pour délivrer le signal de sortie dont le spectre fréquentiel présente une raie à la fréquence LO-EF et une raie à la fréquence LO+IF. La flèche en tiretés illustre la fuite structurelle du signal LO vers le signal de sortie.

La structure habituellement utilisée pour ces mélangeurs est une structure de type GILBERT différentielle telle qu'illustrée schématiquement sur la partie basse de la figure 1, voir aussi le document US 5 715 532 A.

Plus précisément, une telle structure comporte un bloc transducteur différentiel BTC pour convertir le signal d'entrée (tension) présent sur les bornes BE en un courant différentiel. Ce bloc BTC comporte dans le cas présent un étage formant l'étage de sortie, et constitué d'une paire différentielle de transistors T1 et T2, dont les bases respectives sont reliées aux bornes d'entrée BE par deux capacités C6 et C7. Les collecteurs des deux transistors T1 et T2 de l'étage de sortie forment les bornes de sortie de ce bloc transducteur BTC. Bien entendu, le bloc BTC peut comporter plusieurs étages.

Une résistance RP, contribuant à définir la valeur de transductance du bloc,:est connectée entre les émetteurs des transistors T1 et T2. Les transistors T1 et T2 sont polarisés par des moyens de polarisation MPL comportant deux sources de courant SC1 et SC2 respectivement connectées entre la masse et les deux bornes de la résistance RP.

Les moyens de polarisation MPL comportent également deux résistances de base RB1 et RB2 connectées toutes deux à une source de tension ST, cette maille formant un chemin de retour pour les courants de base des transistors T1 et T2.

A la sortie du bloc transconducteur BTC, c'est-à-dire aux collecteurs des transistors T1 et T2 de l'étage de sortie, est connecté un bloc de commutation de courant BCC aiguillant le courant alternativement vers l'une ou l'autre des deux bornes de sortie BS à la fréquence du signal d'oscillateur local LO reçu au niveau des bornes BO. Ce bloc BCC comporte classiquement de deux paires de transistors Q3, Q4 et Q5, Q6.

Chaque résistance ZL, connectée entre les bornes de sortie BS du bloc BCC et l'alimentation Vcc, représente la charge de sortie du mélangeur DTF.

Le transconducteur BTC formé des transistors T1, T2 et de la résistance RP, qui est également utilisé ici pour définir la transconductance du bloc BTC, convertit la puissance ou la tension appliquée à l'entrée BE en un courant différentiel qui est une image supposée linéaire du signal d'entrée. Ce signal linéaire est ensuite découpé par une fonction carrée non linéaire (+1, -1, +1, -1 ...) réalisée par le double commutateur BCC, à la fréquence du signal LO, ce double commutateur faisant office d'aiguilleur dynamique du courant. Le signal de sortie est recueilli aux bornes de la charge différentielle 2ZL.

Au premier ordre, on montre que cette structure équilibrée génère en sortie un signal de sortie exempt de résidu de signal d'oscillateur local.

Cependant, cette absence de signal d'oscillateur local dans le signal de sortie repose sur le caractère parfaitement différentiel de la structure. Or, en pratique, il existe une quantité résiduelle de signal d'oscillateur local dans le signal de sortie en raison du caractère non parfaitement différentiel de la structure. En d'autres termes, les éléments "symétriques" de la structure ne possèdent pas en fait après réalisation sur le silicium des caractéristiques identiques, c'est-à-dire qu'ils ne sont pas "appariés".

Une cause communément invoquée est un mauvais appariement des capacités parasites du commutateur de courant et/ou des deux impédances de charge de sortie ZL.

L'invention vise à appporter une solution à ce problème en adoptant une solution radicalement différente de celle de l'art antérieur qui visait à réduire le défaut d'appariement dynamique de la structure, c'est-à-dire le défaut d'appariement capacitif et résistif.

Après de nombreuses analyses, le demandeur a en effet observé que la cause dominante du défaut d'appariement de la structure différentielle venait non pas d'un défaut d'appariement dynamique, mais d'un défaut d'appariement statique, et plus particulièrement d'un mauvais appariement des courants de repos de la structure différentielle.

L'invention vise donc un meilleur appariement des courants de repos ou de polarisation des transistors de la paire différentielle de l'étage de sortie du bloc transconducteur BTC, c'est-à-dire un meilleur appariement des courants d'émetteur de ces transistors.

Or, les moyens de polarisation classiquement utilisés, tels que ceux illustrés sur la figure 1 sous la référence MPL, présentent de nombreuses causes conduisant à une absence d'appariement.

L'une de ces causes résulte du mauvais appariement des deux sources de courant SC1 et SC2. Par ailleurs, les transistors T1 et T2 polarisés à des niveaux de courant élevés (quelques mA à 10 mA) développent facilement des tensions de décalage (d'offset) de 5 à 10 mV. Or, l'appariement des courants de polarisation dépend non seulement de l'appariement des facteurs β respectifs des transistors, mais également de l'appariement des tensions d'offset respectives de ces transistors.

Par ailleurs, les résistances de polarisation de base RB1 et RB2 induisent un défaut d'appariement très sensible à cause du décalage de courant de base (mauvais appariement des gains DC) que l'on trouve dans les transistors bipolaires, en particulier dans les technologies rapides.

Les ordres de grandeur sont tels que le défaut d'appariement des courants de sortie est de 5 à 10% si l'on suppose un défaut d'appariement des gains des transistors de 10%. La situation peut être pire quand l'appariement des gains se dégrade encore jusqu'à environ 20% ou 30% comme c'est parfois le cas dans les technologies rapides.

L'invention propose donc, pour réduire la quantité résiduelle de signal d'oscillateur local dans le signal de sortie d'un tel mélangeur, d'agir sur l'appariement des courants de repos de la structure, en effectuant un asservissement différentiel des courants de repos de l'étage de sortie du bloc transconducteur, assorti d'une commande de mode commun.

Selon le procédé de l'invention défini dans la revendication 1, on polarise les transistors de l'étage de sortie du bloc transconducteur différentiel de la structure en réalisant un asservissement différentiel des courants d'émetteur (s'il s'agit d'une technologie bipolaire ou de source s'il s'agit d'une technologie MOS) de ces transistors sur un courant de mode commun prédéterminé, c'est-à-dire que l'on asservit à zéro la différence des valeurs des deux courants d'émetteurs tout en asservissant la valeur de chacun de ces courants à une valeur prédéterminée qui est la valeur du courant de mode commun.

En d'autres termes, l'asservissement différentiel des deux courants d'émetteur ou de source de l'étage de sortie du bloc transconducteur vise à rendre ces deux courants de repos égaux. De ce fait, l'appariement des deux courants de sortie, qui sont les deux courants de collecteur, ne dépend alors du défaut d'appariement Δβ des deux transistors que dans un rapport 1/β². Ainsi, pour des valeurs usuelles de β de l'ordre de 50, et un rapport Δβ/β même au pire de l'ordre de 0,5, on obtient un appariement des courants de collecteur des transistors T1 et T2 à 1% près.

Ceci étant, il est nécessaire, non seulement que les deux courants de polarisation soient égaux, mais il est également nécessaire qu'ils soient égaux à un courant de mode commun fixé à l'avance. C'est la raison pour laquelle on effectue également une commande ou asservissement de mode commun.

Les courants de polarisation ou de repos sont les courants d'émetteurs en l'absence de signal (fréquence intermédiaire ou radiofréquence) à l'entrée du bloc transconducteur. En toute rigueur, les courants d'émetteurs en présence de signal d'entrée sont différents des courants d'émetteurs au repos. Ceci étant, en pratique, la moyenne du signal reçu à l'entrée est nulle, et les variations des courants d'émetteurs qui sont corrigées par la boucle d'asservissement selon l'invention ne sont pas les variations dues au signal d'entrée, mais celles qui relèvent du process (défaut d'appariement), de variations de température, etc... Ces variations qui apparaissent dès que le mélangeur est sous tension sont corrigées par la boucle d'asservissement avec une constante de temps relativement grande par rapport aux variations temporelles du signal d'entrée.

En conséquence, au sens de la présente invention et dans la suite du texte, on fait abstraction du signal d'entrée et les courants d'émetteurs ou de source que l'on asservit sont considérés, même en présence de signal d'entrée, comme les courants de polarisation ou de repos des transistors respectifs.

Selon un mode de mise en oeuvre de l'invention, on réalise ledit asservissement différentiel en rebouclant directement ou indirectement entre les émetteurs (sources) et les bases (grilles) des transistors de l'étage de sortie du bloc transconducteur, un amplificateur différentiel, de préférence à transconductance (sortie en courant), dont l'étage d'entrée comporte deux transistors ayant des bases (grilles) reliées, et on fixe le courant de mode commun en appliquant une tension de référence sur les bases (grilles) reliées des transistors de l'amplificateur différentiel. Ceci permet d'appliquer sur les émetteurs des transistors de l'étage de sortie du bloc transconducteur une tension relativement faible.

Lorsque le bloc transconducteur ne comporte qu'un étage, qui est à la fois l'étage d'entrée et l'étage de sortie, le rebouclage de l'amplificateur différentiel est direct, c'est-à-dire que la sortie de l'amplificateur est directement connectée sur les bases des transistors du bloc transconducteur.

Lorsque le bloc transconducteur comporte au moins deux étages mutuellement reliés, c'est-à-dire au moins un étage d'entrée et un étage de sortie, le rebouclage de l'amplificateur est indirect, c'est-à-dire que la sortie de l'amplificateur est connectée sur l'une des électrodes des transistors de l'étage d'entrée du bloc transconducteur et est par conséquent indirectement connectée sur les bases des transistors de l'étage de sortie, c'est-à-dire par l'intermédiaire des transistors de l'étage d'entrée et éventuellement des transistors des étages intermédiaires.

Un tel mode de mise en oeuvre permet ainsi également de n'utiliser qu'un seul amplificateur différentiel pour réaliser à la fois l'asservissement différentiel des courants d'émetteur sur le courant de mode commun, et pour fixer ce courant de mode commun. Une telle solution se distingue d'une autre solution, également possible, qui consisterait à utiliser un amplificateur différentiel pour réaliser l'asservissement des courants d'émetteur sur le courant de mode commun, et une boucle d'asservissement distincte pour réaliser l'asservissement de mode commun, c'est-à-dire fixer la valeur du courant de mode commun.

Il serait possible d'appliquer la tension de référence sur les bases (grilles) reliées des transistors de l'amplificateur différentiel en utilisant directement une source de tension de référence. Cependant, dans ce cas, la valeur du courant de repos dépend de la chute de tension base-émetteur (grille-source) des transistors de l'étage d'entrée de l'amplificateur différentiel, chute de tension qui n'est pas stable en température. Aussi, est-il préférable, dans certaines applications, d'appliquer ladite tension de référence sur les bases reliées des transistors de l'amplificateur différentiel à partir d'une source de courant de référence et d'une résistance de référence mutuellement connectées par un miroir de courant dont la base de l'un des transistors est connectée aux bases reliées des transistors de l'amplificateur différentiel. La formule donnant le courant de polarisation est alors indépendante d'une chute de tension base émetteur d'un transistor bipolaire (ou grille-source d'un transistor à effet de champ à grille isolée (MOS)).

Alors qu'il serait possible de polariser les transistors de l'étage d'entrée de l'amplificateur différentiel avec un courant de polarisation issu d'une source de courant distincte de la source de courant de référence, il est préférable, pour des raisons d'appariement, de polariser ces transistors avec un courant de polarisation issu de ladite source de courant de référence. Ce courant de polarisation peut être alors égal au courant de référence issu de la source de courant de référence, ou bien égal à une fraction de ce courant de référence.

L'invention selon la revendication 5 a également pour objet un dispositif de transposition de fréquence, du type comprenant :
- un bloc transconducteur différentiel pour convertir un signal d'entrée en un courant différentiel et comportant un étage de sortie différentiel à deux transistors,
- des moyens de polarisation des transistors de l'étage de sortie, et
- un circuit de commutation de courant commandé par un signal d'oscillateur local et connecté entre l'étage de sortie du bloc transconducteur et la borne de sortie du dispositif.

Selon une caractéristique générale de l'invention, les moyens de polarisation comportent des moyens de génération d'un courant de mode commun prédéterminé et des moyens d'asservissement aptes à réaliser un asservissement différentiel des deux courants d'émetteurs ou de sources des transistors de l'étage de sortie du bloc transconducteur sur le courant de mode commun.

Selon un mode de réalisation de l'invention, les moyens d'asservissement comprennent un amplificateur différentiel à transconductance, comportant un étage d'entrée à deux transistors dont les bases sont reliées ensemble, dont les émetteurs sont respectivement reliés aux émetteurs des transistors de l'étage de sortie, et dont les collecteurs sont rebouclés directement ou indirectement sur les bases des transistors de l'étage de sortie.

Par ailleurs, les moyens de génération du courant de mode commun comportent une source de tension délivrant une tension prédéterminée sur les bases reliées des transistors de l'étage d'entrée de l'amplificateur différentiel, ainsi que deux résistances de polarisation connectées entre la masse et les émetteurs des transistors de l'étage de sortie du bloc transconducteur.

Selon un mode de réalisation particulièrement avantageux de l'invention, la source de tension de référence comporte une source de courant de référence délivrant un courant de référence prédéterminé, une résistance de référence connectée à la masse, et un miroir de courant connecté entre la source de courant de référence, la résistance de référence et les bases reliées des transistors de l'étage d'entrée de l'amplificateur différentiel.

L'invention a également pour objet un téléphone mobile cellulaire, comprenant un dispositif de transposition de fréquence tel que défini ci-avant.

D'autres avantages et caractéristiques de l'invention apparaîtront à l'examen de la description détaillée de modes de mise en oeuvre et de réalisation nullement limitatifs, et des dessins annexés, sur lesquels :
- la figure 1, déjà décrite, illustre un dispositif de transposition de fréquence équipé de moyens de polarisation selon l'art antérieur;
- la figure 2 est un synoptique très schématique de moyens de polarisation selon l'invention, permettant un asservissement différentiel assorti d'une commande de mode commun, selon l'invention;
- les figures 3 et 3a illustrent plus en détail la structure interne des moyens de polarisation de la figure 2;
- la figure 4 illustre schématiquement une variante de réalisation de l'invention; et
- la figure 5 illustre toujours schématiquement une autre variante de réalisation de l'invention, permettant également de réaliser un asservissement différentiel des courants d'émetteurs des transistors de l'étage de sortie du bloc transconducteur sur un courant de mode commun prédéterminé.

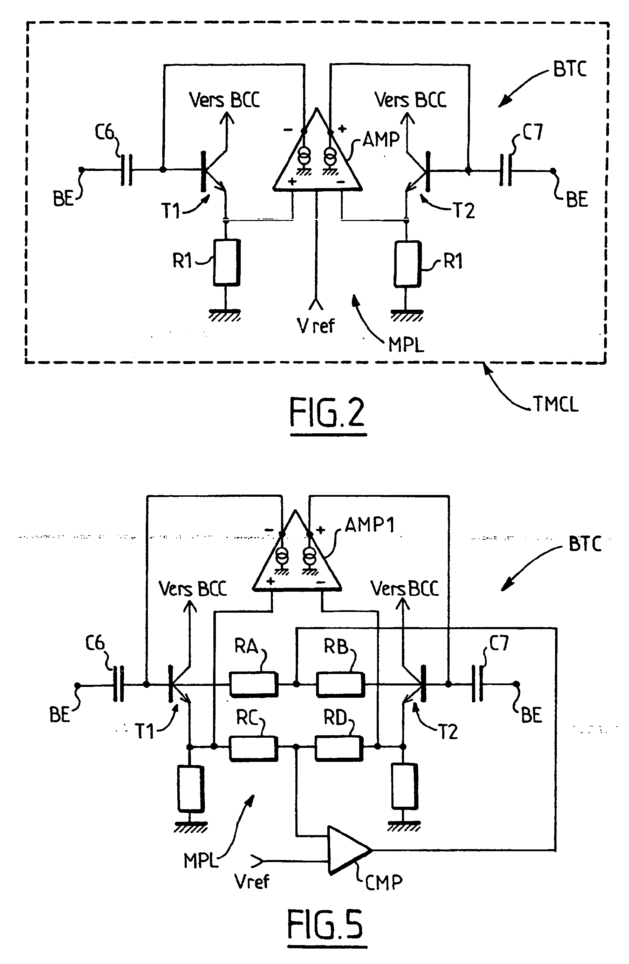

Sur la figure 2, on a représenté uniquement, à des fins de simplification, l'étage de sortie T1, T2 du bloc transconducteur BTC équipé de ces moyens de polarisation MPL. En effet, le reste de la structure du dispositif de transposition de fréquence, c'est-à-dire notamment le bloc de commutation de courant BCC, est identique à celui illustré sur la figure 1. Ce dispositif de transposition de fréquence peut être incorporé dans un téléphone mobile cellulaire TMCL (sur la figure 2 les autres éléments classiques d'un téléphone mobile n'ont pas été représentés à des fins de simplification).

Sur la figure 2, la référence AMP désigne globalement un amplificateur différentiel à transconductance rebouclé entre les émetteurs et les bases des transistors T1 et T2. Par ailleurs, les moyens de polarisation comportent deux résistances de polarisation que l'on a supposé ici identiques et qui sont référencées R1. Ces résistances de polarisation sont connectées entre les émetteurs des transistors T1 et T2 et la masse. Il convient de noter ici que les résistances R1 servent également à fixer la valeur de transconductance de l'étage de sortie du bloc BTC. Ceci étant, il serait possible de découpler la fonction de polarisation et celle de transconductance qui sont liées ici par la même résistance R1, en connectant par exemple entre l'émetteur de chaque transistor T1 et T2 et la base, une résistance de polarisation et, en parallèle aux bornes de cette résistance de polarisation, une capacité en série avec une autre résistance qui permettrait de fixer de la valeur de transconductance.

Dans le cas présent, même si les résistances R1 assurent simultanément des fonctions de polarisation et de transconductance, on ne s'intéresse maintenant qu'à la fonction de polarisation.

Sur la figure 2, la référence Vref désigne une tension de référence qui, appliquée via l'amplificateur différentiel AMP, permet de fixer le courant de mode commun I₀ (courant d'émetteur au repos, c'est-à-dire en l'absence de signal d'entrée, ou courant de polarisation).

La fonction de l'asservissement différentiel et de la commande de mode commun, est alors d'une part de fixer la valeur I₀ du courant de mode commun et d'asservir chacun des courants d'émetteur des transistors T1 et T2 sur cette valeur I₀.

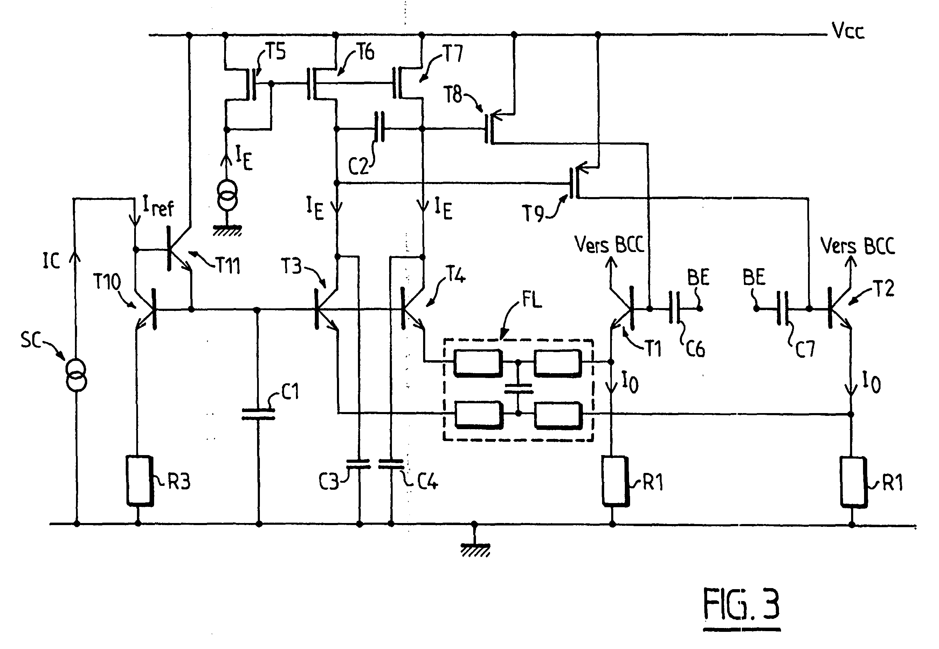

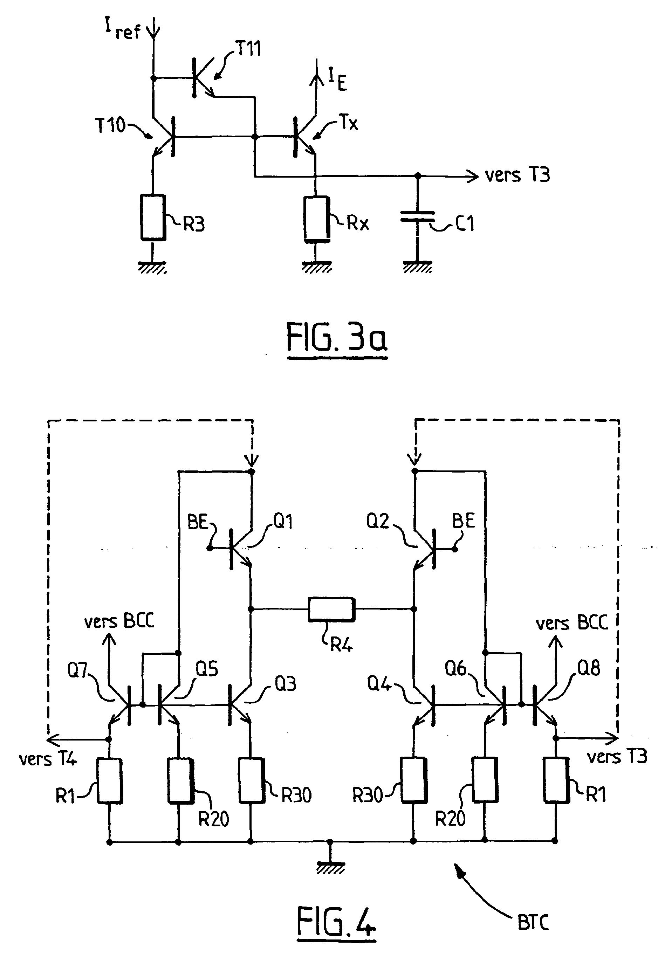

Comme illustré sur la figure 3, l'amplificateur différentiel AMP est formé d'un étage d'entrée comportant une paire différentielle de transistors bipolaires T3 et T4 dont les émetteurs sont respectivement reliés aux émetteurs des transistors T1 et T2 de l'étage de sortie du bloc transconducteur BTC et dont les collecteurs sont rebouclés sur les bases des transistors T1 et T2, par l'intermédiaire de l'étage de sortie de cet amplificateur différentiel qui est formé de deux transistors PMOS T8 et T9.

Les transistors T8 et T9 contribuent à l'obtention du gain de l'amplificateur différentiel et fournissent le courant de base aux transistors T1 et T2. Par ailleurs, l'amplificateur différentiel AMP comporte deux autres transistors NMOS T6 et T7 qui constituent une charge dynamique pour les transistors T3 et T4 et qui permettent la polarisation de ces transistors. Plus précisément, ces transistors T6 et T7 forment les deux sorties d'un miroir de courant dont l'entrée est formée par un troisième transistor NMOS T5. Le miroir de courant permet ainsi de polariser les transistors T3 et T4 avec un courant I_{E}. Ce courant I_{E} est égal à xI_{ref} où I_{ref} est le courant délivré par une source de courant SC.

Il serait possible d'utiliser une source de courant distincte de SC pour générer le courant I_{E}. Cependant, pour des raisons d'appariement, il est préférable que le courant I_{E} soit issu de la source de courant SC. Un exemple d'un tel montage est illustré sur la figure 3a. Sur cette figure, un transistor Tx, polarisé par une résistance Rx, est disposé entre la base du transistor T10 et le transistor T5. L'homme du métier saura ajuster les caractéristiques du transistor Tx et la valeur de la résistance Rx pour obtenir la valeur de x désirée.

L'amplificateur différentiel permet d'asservir les courants d'émetteurs des transistors T1 et T2 à la même valeur. En effet, si l'on suppose par exemple qu'à un instant donné le courant d'émetteur du transistor T1 est supérieur au courant d'émetteur du transistor T2, il en résulte que le courant de collecteur du transistor T4 est inférieur au courant de collecteur du transistor T3. Par conséquent, la tension de grille du transistor T8 est supérieure à la tension de grille du transistor T9. Le transistor T8 conduit alors moins que le transistor T9.

Il en résulte donc une diminution du courant dans la base du transistor T1, ce qui se traduit par une baisse du courant d'émetteur du transistor T1 jusqu'à ce que celui-ci devienne égal au courant d'émetteur du transistor T2.

La fixation du courant de repos ou de polarisation I₀ des transistors T1 et T2 est obtenue en appliquant une tension de référence Vref sur les bases reliées des transistors T3 et T4 de l'amplificateur différentiel.

L'application de cette tension de référence est réalisée ici à partir de la source de courant SC, d'une résistance de référence R3 et d'un miroir de courant formé des transistors T10 et T11, miroir de courant connecté entre la source de courant SC et la résistance R3. Par ailleurs, la base du transistor T10 est connectée aux bases reliées des transistors T3 et T4.

Il en résulte alors, si l'on suppose que le courant I_{E} est égal au courant I_{ref} circulant dans la résistance R3, que le courant de repos I₀ est égal à I_{ref} (R3/R1-1).

On voit donc que le courant I₀ ne dépend pas d'une chute de tension base-émetteur d'un transistor bipolaire, ce qui aurait été le cas si l'on avait par exemple appliqué directement sur les bases des transistors T3 et T4 une tension de référence issue d'une source de tension.

L'homme du métier remarque donc que l'appariement final des courants de repos des transistors de l'étage de sortie ne dépend essentiellement que de l'appariement des deux résistances R1. Or, les technologies actuelles permettent de réaliser des appariements résistifs de l'ordre de 0,5%. Toutes les autres causes de défaut d'appariement sont divisées par le gain de la boucle d'asservissement. Elles sont donc bien moindres que dans une structure de l'art antérieur.

Outre les éléments qui viennent d'être décrits, les moyens de polarisation comportent également une capacité 1 connectée entre les bases reliées des transistors T3 et T4 et la masse et qui permet un découplage des bases à haute fréquence. Par ailleurs, tant la capacité C2 qui est connectée entre les collecteurs des transistors T3 et T4, que les capacités C3 et C4 qui sont respectivement connectées entre les collecteurs des transistors T3 et T4 et la masse, permettent une meilleure stabilité de la boucle d'asservissement à haute fréquence (mode différentiel pour la capacité C2 et mode commun pour les capacités C3 et C4).

Enfin, il est également possible, mais non indispensable, de connecter entre les émetteurs des transistors T3 et T4, et les émetteurs des transistors T1 et T2, un filtre passe-bas FL, ce qui permet de se débarrasser d'une partie du signal d'entrée (qui est à une fréquence intermédiaire dans le cas d'un mélangeur élévateur de fréquence ou bien à une fréquence du type radiofréquence dans le cas d'un mélangeur abaisseur de fréquence).

Alors que sur la figure 3, le bloc transconducteur ne comporte qu'un seul étage composé des transistors T1 et T2, la figure 4 illustre schématiquement les éléments essentiels d'un bloc transconducteur comportant un étage d'entrée formé des transistors 1 et Q2, un étage de sortie formé des transistors Q7 et Q8, et un étage intermédiaire formé des transistors Q3, Q4 et Q5, Q6. L'amplificateur différentiel d'asservissement, représenté en tiretés sur la figure 4, est ici connecté entre les émetteurs des transistors de l'étage de sortie Q7, Q8 et les collecteurs des transistors Q1, Q2 de l'étage d'entrée. Ce rebouclage est par conséquent indirect sur les bases des transistors Q7 et Q8. Il serait également possible, d'une façon plus générale, de connecter l'amplificateur différentiel sur l'une des électrodes (base, collecteur, émetteur) des transistors de l'étage d'entrée.

Au lieu de régler le courant de mode commun au travers de l'amplificateur différentiel AMP, il serait également possible, comme illustré sur la figure 5, de prévoir une boucle d'asservissement de mode commun distincte pour régler la valeur du courant I₀.

Plus précisément, alors que l'amplificateur différentiel AMP1 reste toujours rebouclé entre les émetteurs et les bases des transistors T1 et T2 de l'étage de sortie du bloc transconducteur BTC, la boucle d'asservissement supplémentaire comporte un amplificateur linéaire CMP dont l'une des entrées reçoit la tension de référence Vref et dont l'autre entrée est connectée au point milieu d'un pont résistif RC et RD disposé entre les émetteurs des transistors T1 et T2.

Par ailleurs, la sortie de l'amplificateur CMP est connectée au point milieu d'un autre pont résistif RA et RB connecté entre les bases des transistors T1 et T2.

Cependant, un tel montage nécessite une surface de silicium supérieure au montage de la figure 2.

Les modes de réalisation et de mise en oeuvre qui viennent d'être décrits utilisent en partie des transistors bipolaires npn.

Bien entendu, l'invention est également réalisable avec des transistors pnp ou bien avec des transistors MOS, les émetteurs, bases et collecteurs des transistors bipolaires devenant respectivement les sources, grilles et drains des transistors MOS.

Par ailleurs, les moyens de polarisation selon l'invention qui ont été décrits ci-avant ne sont pas limités à l'application particulière d'un mélangeur, mais permettent de polariser en général toute paire différentielle de transistors dans le but d'obtenir les avantages qui ont été évoqués ci-avant.

## Revendications

1. Procédé de réduction de la quantité résiduelle de signal d'oscillateur local dans le signal de sortie d'un dispositif de transposition de fréquence à structure de type GILBERT différentielle, **caractérisé par le fait qu'**on polarise les transistors (T1, T2) de l'étage de sortie du bloc transconducteur différentiel de ladite structure en réalisant un asservissement différentiel des deux courants d'émetteurs ou de sources de ces transistors sur un courant de mode commun prédéterminé (I₀).

2. Procédé selon la revendication 1, **caractérisé par le fait qu'**on réalise ledit asservissement différentiel en rebouclant directement ou indirectement entre les émetteurs ou sources et les bases ou grilles des transistors (T1, T2) de l'étage de sortie du bloc transconducteur, un amplificateur différentiel à transconductance dont l'étage d'entrée comporte deux transistors (T3, T4) ayant des bases ou grilles reliées, et **par le fait qu'**on fixe le courant de mode commun en appliquant une tension de référence (Vref) sur les bases ou grilles reliées des transistors (T3, T4) de l'amplificateur différentiel.

3. Procédé selon la revendication 2, **caractérisé par le fait qu'**on applique ladite tension de référence sur les bases ou grilles reliées des transistors (T3, T4) de l'amplificateur différentiel à partir d'une source de courant de référence (SC) et d'une résistance de référence (R3) mutuellement connectées par un miroir de courant (T10, T11) dont la base ou grille de l'un des transistors (T10) est connectée aux bases reliées des transistors (T3, T4) de l'amplificateur différentiel.

4. Procédé selon la revendication 3, **caractérisé par le fait qu'**on polarise les transistors (T3, T4) de l'étage d'entrée de l'amplificateur différentiel avec un courant de polarisation (I_{E}) issu de ladite source de courant de référence (SC).

5. Dispositif de transposition de fréquence, du type comprenant un bloc transconducteur différentiel (BTC) pour convertir un signal d'entrée en un courant différentiel et comportant un étage de sortie différentiel à deux transistors (T1, T2), des moyens de polarisation (MPL) des transistors de l'étage de sortie, et un circuit de commutation de courant (BCC) commandé par un signal d'oscillateur local et connecté entre l'étage de sortie du circuit transconducteur et la borne de sortie (BS) du dispositif, **caractérisé par le fait que** les moyens de polarisation (MPL) comportent des moyens de génération d'un courant de mode commun prédéterminé (I₀) et des moyens d'asservissement aptes à réaliser un asservissement différentiel des deux courants d'émetteur ou de source des transistors (T1, T2) de l'étage de sortie du bloc transconducteur sur le courant de mode commun (I₀).

6. Dispositif selon la revendication 5, **caractérisé par le fait que** les moyens d'asservissement comprennent un amplificateur différentiel à transconductance (AMP) comportant un étage d'entrée à deux transistors (T3, T4) dont les bases ou grilles sont reliées ensemble, dont les emetteurs ou sources sont respectivement reliés aux émetteurs ou sources des transistors (T1, T2) de l'étage de sortie, et dont les collecteurs ou drains sont rebouclés directement ou indirectement sur les bases ou grilles des transistors de l'étage de sortie, et **par le fait que** les moyens de génération du courant de mode commun comportent une source de tension délivrant une tension prédéterminée (Vref) sur les bases ou grilles reliées des transistors (T3, T4) de l'étage d'entrée de l'amplificateur différentiel, ainsi que deux résistances de polarisation (R1) connectées entre la masse et les emetteurs ou sources des transistors (T1, T2) de l'étage de sortie du bloc transconducteur.

7. Dispositif selon la revendication 6, **caractérisé par le fait que** le bloc transconducteur comporte au moins un étage d'entrée (Q1, Q2) et un étage de sortie (Q7, Q8), et **par le fait que** les collecteurs ou drains des transistors (T3, T4) de l'amplificateur différentiel sont connectés sur l'une des électrodes des transistors (Q1, Q2) de l'étage d'entrée du bloc transconducteur.

8. Dispositif selon la revendication 6 ou 7, **caractérisé par le fait que** les moyens de génération du courant de mode commun comportent un filtre passe-bas (FL) résistif capacitif connecté entre les émetteurs ou sources des transistors (T3, T4) de l'étage d'entrée de l'amplificateur différentiel, et les émetteurs ou sources des transistors (T1, T2) de l'étage de sortie du bloc transconducteur différentiel.

9. Dispositif selon la revendication 6, 7 ou 8, **caractérisé par le fait que** la source de tension comporte une source de courant (SC) délivrant un courant prédéterminé, une résistance de référence (R3) connectée à la masse et un miroir de courant (T10, T11) connecté entre la source de courant (SC), la résistance de référence (R3) et les bases ou grilles reliées des transistors (T3, T4) de l'étage d'entrée de l'amplificateur différentiel.

10. Dispositif selon la revendication 9, **caractérisé par le fait que** les moyens d'asservissement comportent un miroir de courant (T5, T6, T7) connecté entre ladite source de courant de référence (SC) et les collecteurs ou drains des transistors (T3, T4) de l'étage d'entrée de l'amplificateur différentiel.

11. Téléphone mobile cellulaire, **caractérisé par le fait qu'**il comprend un dispositif de transposition de fréquence tel que défini dans l'une des revendications 5 à 10.

## Claims

1. Process for reducing the residual quantity of local oscillator signal in the output signal from a frequency transposition device with differential GILBERT type structure, **characterized in that** the transistors (T1, T2) of the output stage of the differential transconductor block of the said structure are biased by carrying out differential slaving of the two emitter currents or source currents of these transistors to a predetermined common mode current (I₀).

2. Process according to Claim 1, **characterized in that** the said differential slaving is carried out by looping back directly or indirectly between the emitters or sources and the bases or gates of the transistors (T1, T2) of the output stage of the transconductor block, a differential amplifier with transconductance whose input stage comprises two transistors (T3, T4) having linked bases or gates, and **in that** the common mode current is fixed by applying a reference voltage (Vref) to the linked bases or gates of the transistors (T3, T4) of the differential amplifier.

3. Process according to Claim 2, **characterized in that** the said reference voltage is applied to the linked bases or gates of the transistors (T3, T4) of the differential amplifier from a reference current source (SC) and from a reference resistor (R3) which are mutually connected by a current mirror (T10, T11), the base or gate of one of whose transistors (T10) is connected to the linked bases of the transistors (T3, T4) of the differential amplifier.

4. Process according to Claim 3, **characterized in that** the transistors (T3, T4) of the input stage of the differential amplifier are biased with a bias current (I_{E}) emanating from the said reference current source (SC).

5. Frequency transposition device, of the type comprising a differential transconductor block (BTC) for converting an input signal into a differential current and comprising a differential output stage with two transistors (T1, T2), means (MPL) of biasing the transistors of the output stage, and a current switching circuit (BCC) controlled by a local oscillator signal and connected between the output stage of the transconductor circuit and the output terminal (BS) of the device, **characterized in that** the biasing means (MPL) comprise means for generating a predetermined common mode current (I₀) and slaving means able to carry out differential slaving of the two emitter currents or source currents of the transistors (T1, T2) of the output stage of the transconductor block to the common mode current (I₀).

6. Device according to Claim 5, **characterized in that** the slaving means comprise a differential amplifier with transconductance (AMP) comprising an input stage with two transistors (T3, T4) whose bases or gates are linked together, whose emitters or sources are linked respectively to the emitters or sources of the transistors (T1, T2) of the output stage, and whose collectors or drains are looped back directly or indirectly to the bases or gates of the transistors of the output stage, and **in that** the means for generating the common mode current comprise a voltage source delivering a predetermined voltage (Vref) to the linked bases or gates of the transistors (T3, T4) of the input stage of the differential amplifier, as well as two bias resistors (R1) connected between earth and the emitters or sources of the transistors (T1, T2) of the output stage of the transconductor block.

7. Device according to Claim 6, **characterized in that** the transconductor block comprises at least one input stage (Q1, Q2) and an output stage (Q7, Q8), and **in that** the collectors or drains of the transistors (T3, T4) of the differential amplifier are connected to one of the electrodes of the transistors (Q1, Q2) of the input stage of the transconductor block.

8. Device according to Claim 6 or 7, **characterized in that** the means for generating the common mode current comprise a resistive capacitive low-pass filter (FL) connected between the emitters or sources of the transistors (T3, T4) of the input stage of the differential amplifier, and the emitters or sources of the transistors (T1, T2) of the output stage of the differential transconductor block.

9. Device according to Claim 6, 7 or 8, **characterized in that** the voltage source comprises a current source (SC) delivering a predetermined current, a reference resistor (R3) connected to earth and a current mirror (T10, T11) connected between the current source (SC), the reference resistor (R3) and the linked bases or gates of the transistors (T3, T4) of the input stage of the differential amplifier.

10. Device according to Claim 9, **characterized in that** the slaving means comprise a current mirror (T5, T6, T7) connected between the said reference current source (SC) and the collectors or drains of the transistors (T3, T4) of the input stage of the differential amplifier.

11. Cellular mobile telephone, **characterized in that** it comprises a frequency transposition device such as defined in one of Claims 5 to 10.

## Patentansprüche

1. Verfahren zur Reduzierung der Restmenge eines lokalen Oszillatorsignals im Ausgangssignal einer Frequenzumsetzungsvorrichtung mit einem differentiellen Aufbau vom GILBERT-Typ, **dadurch gekennzeichnet, dass** die Transistoren (T1, T2) der Ausgangsstufe des differentiellen Transkonduktorblocks des Aufbaus polarisiert werden, indem eine differentielle Regelung der beiden Emitter- oder Sourceströme dieser Transistoren auf einen vorbestimmten Gleichtaktstrom (I₀) durchgeführt wird.

2. Verfahren nach Anspruch 1, **dadurch gekennzeichnet, dass** die differentielle Regelung durchgeführt wird, indem ein Transkonduktanz-Differentialverstärker, dessen Eingangsstufe zwei Transistoren (T3, T4) mit verbundenen Basen oder Gates aufweist, zwischen den Emittern oder Sourcen und den Basen oder Gates der Transistoren (T1, T2) der Ausgangsstufe des differentiellen Transkonduktorblocks direkt oder indirekt rückgeschleift wird, und dass der Gleichtaktstrom festgelegt wird, indem eine Bezugsspannung (Vref) an die verbundenen Basen oder Gates der Transistoren (T3, T4) des Differentialverstärkers angelegt wird.

3. Verfahren nach Anspruch 2, **dadurch gekennzeichnet, dass** die Bezugsspannung ausgehend von einer Bezugsstromquelle (SC) und von einem Bezugswiderstand (R3), die miteinander über einen Stromspiegel (T10, T11) verbunden sind, dessen Basis oder Gate eines der Transistoren (T10) mit den verbundenen Basen der Transistoren (T3, T4) des Differentialverstärkers verbunden ist, an die verbundenen Basen oder Gates der Transistoren (T3, T4) des Differentialverstärkers angelegt wird.

4. Verfahren nach Anspruch 3, **dadurch gekennzeichnet, dass** die Transistoren (T3, T4) der Eingangsstufe des Differentialverstärkers mit einem Polarisationsstrom (I_{E}) polarisiert werden, der von der Bezugsstromquelle (SC) stammt.

5. Vorrichtung zur Frequenzumsetzung von der Art, die einen differentiellen Transkonduktorblock (BTC) aufweist, um ein Eingangssignal in einen Differentialstrom umzuwandeln, und die eine differentielle Ausgangsstufe mit zwei Transistoren (T1, T2), Polarisationsmittel (MPL) der Transistoren der Ausgangsstufe und eine Stromumschalteinheit (BCC) aufweist, die von einem lokalen Oszillatorsignal gesteuert wird und zwischen der Ausgangsstufe der Transduktorschaltung und der Ausgangsklemme (BS) der Vorrichtung angeschlossen ist, **dadurch gekennzeichnet, dass** die Polarisationsmittel (MPL) Mittel zur Erzeugung eines vorbestimmten Gleichtaktstroms (I₀) und Regelmittel aufweisen, die eine differentielle Regelung der beiden Emitter- oder Sourceströme der Transistoren (T1, T2) der Ausgangsstufe des Transduktorblocks auf den Gleichtaktstrom (I₀) aufweisen.

6. Vorrichtung nach Anspruch 5, **dadurch gekennzeichnet, dass** die Regelmittel einen Transkonduktanz-Differentialverstärker (AMP) aufweisen, der eine Eingangsstufe mit zwei Transistoren (T3, T4) enthält, deren Basen oder Gates miteinander verbunden sind, deren Emitter bzw. Sourcen mit den Emittern bzw. Sourcen der Transistoren (T1, T2) der Ausgangsstufe verbunden sind, und deren Kollektoren oder Drains direkt oder indirekt auf die Basen oder Gates der Transistoren der Ausgangsstufe rückgeschleift sind, und dass die Mittel zur Erzeugung des Gleichtaktstroms eine Spannungsquelle, die eine vorbestimmte Spannung (Vref) an den verbundenen Basen oder Gates der Transistoren (T3, T4) der Eingangsstufe des Differentialverstärkers liefert, sowie zwei Polarisationswiderstände (RI) aufweisen, die zwischen Masse und den Emittern oder Sourcen der Transistoren (T1, T2) der Ausgangsstufe des Transduktorblocks angeschlossen sind.

7. Vorrichtung nach Anspruch 6, **dadurch gekennzeichnet, dass** der Transkonduktorblock mindestens eine Eingangsstufe (Q1, Q2) und eine Ausgangsstufe (Q7, Q8) aufweist, und dass die Kollektoren oder Drains der Transistoren (T3, T4) des Differentialverstärkers an eine der Elektroden der Transistoren (Q1, Q2) der Eingangsstufe des Transduktorblocks angeschlossen sind.

8. Vorrichtung nach Anspruch 6 oder 7, **dadurch gekennzeichnet, dass** die Mittel zur Erzeugung des Gleichtaktstroms ein ohmsch-kapazitives Tiefpassfilter (FL) aufweisen, das zwischen den Emittern oder Sourcen der Transistoren (T3, T4) der Eingangsstufe des Differentialverstärkers und den Emittern oder Sourcen der Transistoren (T1, T2) der Ausgangsstufe des differentiellen Transduktorblocks angeschlossen sind.

9. Vorrichtung nach Anspruch 6, 7 oder 8, **dadurch gekennzeichnet, dass** die Spannungsquelle eine Stromquelle (SC), die einen vorbestimmten Strom liefert, einen Bezugswiderstand (R3), der an Masse liegt, und einen Stromspiegel (T10, T11) aufweist, der zwischen der Stromquelle (SC), dem Bezugswiderstand (R3) und den verbundenen Basen oder Gates der Transistoren (T3, T4) der Eingangsstufe des Differentialverstärkers angeschlossen ist.

10. Vorrichtung nach Anspruch 9, **dadurch gekennzeichnet, dass** die Regelmittel einen Stromspiegel (T5, T6, T7) aufweisen, der zwischen der Bezugsstromquelle (SC) und den Kollektoren oder Drains der Transistoren (T3, T4) der Eingangsstufe des Differentialverstärkers angeschlossen ist.

11. Zellulares Mobiltelefon, **dadurch gekennzeichnet, dass** es eine Vorrichtung zur Frequenzumsetzung aufweist, wie sie in einem der Ansprüche 5 bis 10 definiert ist.
